# EUROPÄISCHE PATENTSCHRIFT

(11) **EP 1 373 985 B1**
(45) Veröffentlichungstag und Bekanntmachung des Hinweises auf die Patenterteilung: **21.05.2008**
(21) Anmeldenummer: 02724261.9
(22) Anmeldetag: 28.03.2002
(51) Int. Cl.: G03H 1/00, G03H 1/08, G03F 7/20

(54) **LITHOGRAPH MIT STRAHLFÜHRUNG UND VERFAHREN ZUM HERSTELLEN DIGITALER HOLOGRAMME IN EINEM SPEICHERMEDIUM**
LITHOGRAPHY SYSTEM WITH BEAM GUIDANCE AND METHOD FOR PRODUCING DIGITAL HOLOGRAMS IN A STORAGE MEDIUM
APPAREIL DE LITHOGRAPHE A FAISCEAU GUIDÉ ET PROCÉDÉ POUR PRODUIRE DES HOLOGRAMMES NUMERIQUES DANS UN SUPPORT D'ENREGISTREMENT

(30) Priorität: 30.03.2001 DE 10116058
(43) Veröffentlichungstag der Anmeldung: 02.01.2004
(73) Patentinhaber: tesa scribos GmbH, 69126 Heidelberg (DE)
(72) Erfinder: NOEHTE, Steffen, 69469 Weinheim (DE); DIETRICH, Christoph, 69126 Heidelberg (DE); THOMANN, Robert, 69121 Heidelberg (DE); STADLER, Stefan, 22359 Hamburg (DE); LEIBER, Jörn, 22529 Hamburg (DE)
(74) Vertreter: Rox, Thomas
(86) Internationale Anmeldenummer: PCT/EP2002/003499
(87) Internationale Veröffentlichungsnummer: WO 2002/079883

(56) Entgegenhaltungen:
- DE-A- 19 939 617
- US-A- 3 925 785
- US-A- 4 688 932

## Beschreibung

Die vorliegende Erfindung betrifft einen Lithographen zum Herstellen digitaler Hologramme in einem Speichermedium. Insbesondere weist der Lithograph eine Lichtquelle zum Erzeugen eines Schreibstrahls, Antriebsmittel zum zweidimensionalen Bewegen des Schreibstrahls relativ zum Speichermedium und ein erstes Objektiv zum Fokussieren des Schreibstrahls auf das zu beschreibende Speichermedium auf. Darüber hinaus betrifft die Erfindung ein Verfahren zum Herstellen digitaler Hologramme in einem Speichermedium.

Digitale Hologramme sind zweidimensionale Hologramme, die aus einzelnen Punkten mit unterschiedlichen optischen Eigenschaften bestehen und aus denen bei Beleuchtung mit einer kohärenten elektromagnetischen Welle, insbesondere Lichtwelle durch Beugung in Transmission oder Reflexion Bilder und/oder Daten reproduziert werden. Die unterschiedlichen optischen Eigenschaften der einzelnen Punkte können Reflexionseigenschaften beispielsweise durch Oberflächentopographie, variierende optische Weglängen im Material des Speichermediums (Brechungsindizes) oder Farbwerte des Materials sein.

Die optischen Eigenschaften der einzelnen Punkte werden von einem Computer berechnet, es handelt sich somit um sogenannte computergenerierte Hologramme (CGH). Mit Hilfe des fokussierten Schreibstrahls werden während des Schreibens des Hologramms die einzelnen Punkte des Hologramms in das Material eingeschrieben, wobei der Fokus im Bereich der Oberfläche oder im Material des Speichermediums liegt. Eine Fokussierung bewirkt im Bereich des Fokus eine geringe Einwirkungsfläche auf das Material des Speichermediums, so daß eine Vielzahl von Punkten des Hologramms in einem kleinen Bereich geschrieben werden kann. Die optische Eigenschaft des jeweils geschriebenen Punktes hängt dabei von der Intensität des Schreibstrahls ab. Dazu wird der Schreibstrahl in zwei Dimensionen mit variierender Intensität über die Oberfläche des Speichermediums gescannt. Die Modulation der Intensität des Schreibstrahls erfolgt dabei entweder über eine interne Modulation der Lichtquelle, beispielsweise eine Laserdiode, oder über eine externe Modulation eines Schreibstrahls außerhalb der Lichtquelle, beispielsweise mit Hilfe von optoelektronischen Elementen. Darüber hinaus kann die Lichtquelle als gepulster Laser ausgebildet sein, dessen Pulslängen steuerbar sind, so dass über die Pulslängen eine Steuerung der Intensität des Schreibstrahls erfolgen kann.

Durch das Abscannnen des intensitätsmodulierten Schreibstrahls entsteht somit eine Fläche mit einer unregelmäßigen Punkteverteilung, das digitale Hologramm. Dieses kann zum Kennzeichnen und Individualisieren beliebiger Gegenstände eingesetzt werden.

Scannende lithographische Systeme sind an sich weit verbreitet. Beispielsweise werden scannende optische Systeme in herkömmliche Laserdrucker eingebaut. Diese Systeme können jedoch zur Herstellung von Hologrammen nicht eingesetzt werden, da sich die Anforderungen für diesen Anwendungszweck gegenüber denen bei Laserdruckern deutlich unterscheiden. Die Auflösung liegt bei guten Drucksystemen bei etwa 2500 dpi, während bei der Herstellung von Hologrammen eine Auflösung von etwa 25.000 dpi erforderlich ist. Außerdem werden bei der digitalen Holographie nur vergleichsweise kleine Flächen beschrieben. Diese sind beispielsweise 1 bis 5 mm² groß, wobei auch andere Größen möglich sind. Die Genauigkeit des Schreibrasters muß bei einem Lithographen zur Herstellung digitaler Hologramme von beispielsweise 1000 x 1000 Punkten auf einer Fläche von 1 x 1 mm² etwa ± 0,1 µm in beide orthogonale Richtungen betragen. Darüber hinaus sollte die Schreibgeschwindigkeit etwa 1 Mpixel/s betragen, damit jeweils ein Hologramm in einer Zeit von ca. 1s geschrieben werden kann.

Digitale Hologramme können mittels konventioneller Scanmethoden hergestellt werden, bei denen mit stehender Optik der Winkel des einfallenden Strahles variiert wird. Auf diesem Prinzip arbeiten beispielsweise Scanspiegellithographen mit Galvo- und/oder Polygonscannern.

Aus der US 3 925 785 A ist eine Vorrichtung zur Erzeugung eines Musters, insbesondere einer Halbleiterschaltung bekannt. Die bekannte Vorrichtung weist einen Schreibstrahl auf, der in Abhängigkeit von einem in einer Speichervorrichtung gespeicherten Muster von einem Modulator moduliert wird. Zum Abscannen der Oberfläche des zu beschreibenden Objekts wird ein den Schreibstrahl auf das Objekt lenkender erster Spiegel in x-Richtung verfahren. Zur Erzeugung eines die Bewegung des Schreibstrahls anzeigenden Signals ist ein zweiter Strahl vorgesehen, der über einen zweiten, zusammen mit dem ersten Spiegel verfahrenen Spiegel auf eine Code-Platte gelenkt wird. Die Code-Platte weist transparente und undurchlässige Abschnitte auf, so dass mit Hilfe eines in Strahlrichtung hinter der Code-Platte vorgesehenen Photodetektors die Bewegung des zweiten Strahls und somit auch die Bewegung des Schreibstrahls relativ zu dem zu beschreibenden Objekt überwacht werden kann. Wenn mit Hilfe des Photodetektors festgestellt wird, dass der Schreibstrahl in x-Richtung über die gesamte Länge des zu beschreibenden Objekts verschoben wurde, wird das Objekt mit Hilfe eines Schrittmotors um eine vorgegebene Distanz in y-Richtung verschoben. Auf diese Weise kann die gesamte Fläche des zu beschreibenden Objekts mit dem Schreibstrahl abgescannt werden.

Bei allen bisher bekannten Scanmethoden besteht ein Nachteil darin, dass keine Steuerung der genauen Positionierung des Schreibstrahls möglich ist, die bei den zu erreichenden Schreibgeschwindigkeiten ein vorgegebenes Punktraster des digitalen Hologramms einzuhalten in der Lage ist.

Der vorliegenden Erfindung liegt daher das technische Problem zugrunde, mittels optischer Lithographie computergenerierte Hologramme möglichst schnell und mit geringem Aufwand bei gleichzeitiger genauer Steuerung der Positionierung des Schreibstrahls zu schreiben.

Das zuvor aufgezeigte technische Problem wird gemäß einer ersten Lehre der Erfindung durch ein Verfahren zum Herstellen digitaler Hologramme in einem Speichermedium, bei dem ein Schreibstrahl auf das Speichermedium fokussiert und zweidimensional relativ zum Speichermedium bewegt wird, bei dem ein Abtaststrahl auf eine eine Mehrzahl von Spuren aufweisende Strahlführungsmaske fokussiert und zweidimensional relativ zur Strahlführungsmaske bewegt wird, wobei die Bewegung des Abtaststrahls mit der Bewegung des Schreibstrahls gekoppelt wird, bei dem dann, wenn die Position des Abtaststrahls während der Bewegung entlang der abzutastenden Spur der Strahlführungsmaske von der abgetasteten Spur um einen vorgegebenen Wert abweicht, ein Positionsregelsignal erzeugt wird, bei dem mit Hilfe des Positionsregelsignals die Position des Schreibstrahls auf dem Speichermedium geregelt wird, und bei dem das Hologramm durch punktweises Einbringen von Strahlungsenergie geschrieben wird, wobei die Intensität des Schreibstrahls in Abhängigkeit von der Position des Schreibstrahls auf dem Speichermedium gesteuert wird.

Erfindungsgemäß ist also erkannt worden, dass mit Hilfe eines mit dem Schreibstrahl in seiner Bewegung gekoppelten Abtaststrahls ein Positionsregelsignal erzeugt werden kann, mit dem die räumliche Position des Abtaststrahls und somit des Schreibstrahls entlang vorgegebener Spuren geregelt werden kann. Dabei sind bevorzugt die Spuren parallel, also in einem orthogonalen Raster angeordnet, dieses ist jedoch nicht zwingend erforderlich. Mit Hilfe einer zusätzlichen zeitlichen Triggerinformation und Intensitätsinformation, die grundsätzlich unabhängig von der Strahlführungsmaske erzeugt werden können, kann das digitale Hologramm punktweise geschrieben werden.

Die Scanbewegung des Schreibstrahls und des Abtaststrahls scannen verlaufen mit einer Geschwindigkeit, die geringer als die Geschwindigkeit der Scanbewegung der Regelbewegung zum Nachführen der Strahlen ist. Man kann auch von einem langsamen Scannen und einem schnellen Nachführen sprechen.

Wie zuvor ausgeführt, wird das Positionsregelsignal dann erzeugt, wenn der Abtaststrahl um einen vorgegebenen Wert von der abzutastenden Spur abweicht. Dieser Wert wird innerhalb der Messgenauigkeit so eingestellt, dass die Regelung in der erforderlichen Geschwindigkeit erfolgen kann. Der Wert kann dabei auch gleich Null sein, so dass jede Abweichung zu einem Positionsregelsignal führt.

In bevorzugter Weise wird der Abtaststrahl in einem vorgegebenen Bewegungsverhältnis zum Schreibstrahl bewegt. Somit kann der Abtaststrahl eine Strahlführungsmaske abscannen, deren Fläche größer als der zu beschreibende Bereich des Speichermediums ist. Ist die Strahlführungsmaske beispielsweise 10-fach größer als das zu erzeugende Hologramm, so ist die Bewegung des Abtaststrahls im Verhältnis 10:1 proportional zur Bewegung des Schreibstrahls vergrößert. Soll also beispielsweise ein Hologramm mit einer Fläche von 1x1 mm² beschrieben werden, so scannt der Abtaststrahl eine Strahlführungsmaske mit einer Fläche von 10x10 mm² ab. Die vorgenannten Größen sind beispielhaft und stellen keine Beschränkung der Erfindung dar.

Weiter ist es bevorzugt, dass der Abtaststrahl auf eine Größe fokussiert wird, die maximal der Spurabmessung der Strahlführungsmaske entspricht. Somit wird sichergestellt, dass nur die interessierende Spur abgetastet wird und ein ausreichend genaues Positionsregelsignal erzeugt werden kann.

Die optischen Eigenschaften der Spuren können in unterschiedlicher Weise ausgebildet sein, wobei jeweils Techniken eingesetzt werden, die an sich aus dem Stand der Technik, insbesondere von optischen Speichermedien wie Compact Disc (CD) oder Digital Versatile Disc (DVD) bekannt sind.

Bei einer ersten Ausführungsform weisen die Spuren der Strahlführungsmaske eine von der umgebenden Oberfläche seitlich neben den Spuren unterschiedliche Reflektivität auf, so dass der von der Oberfläche der Strahlführungsmaske reflektierte Strahl mit einem mindestens zwei Sensorflächen aufweisenden Detektor detektiert werden kann. Aus der Intensitätsverteilung des auf der Detektorfläche fokussierten reflektierten Abtaststrahls wird dann das Positionsregelsignal abgeleitet. Dabei weist der Detektor, wie auch bei allen weiteren Ausführungsformen, mindestens zwei Detktorflächen auf, aus denen sich die Richtung der Abweichung des Abtaststrahls seitlich zur Abtastbewegung entlang der Spur ableiten lässt. Ebenso sind mehr als zwei Detektorflächen einsetzbar, mit denen die Abweichung noch genauer und zudem weitere Abbildungseigenschaften wie Fokusfehler, Trackfehler, Trigger oder Bewegungsrichtung ableiten lassen.

Bei einer zweiten Ausführungsform weisen die Spuren der Strahlführungsmaske eine von der umgebenden Oberfläche seitlich neben den Spuren unterschiedliche Transmissionseigenschaft auf, so dass der durch die Strahlführungsmaske transmittierte Strahl mit einem mindestens zwei Sensorflächen aufweisenden Detektor detektiert werden kann. Aus der Intensitätsverteilung des transittierten derart gemessenen Strahls wird dann das Positionsregelsignal abgeleitet.

Es können auch Abschnitte mit reflektierenden und mit transmittierenden Eigenschaften miteinander in einer Spur kombiniert werden. Dabei kann beispielsweise der reflektierte Strahlanteil zum Erzeugen des Positionsregelsignals verwendet werden, während der transmittierte Strahlanteil zum Erzeugen eines Triggersignals herangezogen wird.

Bei einer dritten Ausführungsform weisen die Spuren der Strahlführungsmaske eine Oberflächenstruktur, beispielsweise in Form von Rillen auf, so dass der an der Oberfläche der Strahlführungsmaske reflektierend gebeugte Strahl detektiert werden kann. Aus der Intensitätsverteilung des reflektierten Strahls, der sich im wesentlichen aus der Überlagerung der nullten und beiden ersten Beugungsordnungen ergibt, wird dann das Positionsregelsignal abgeleitet. Das erzeugte Positionsregelsignal wird dann auch als Push-Pull-Signal bezeichnet.

Weiter ist es bevorzugt, dass der Abtaststrahl drei nebeneinander verlaufende Teilstrahlen aufweist, so dass zusätzlich zur Intensität des mittleren Strahls aus den Intensitäten der beiden Randstrahlen das Positionsregelsignal abgeleitet werden kann. Verlaufen dabei die beiden Randstrahlen beispielsweise auf den sich gegenüberliegenden Rändern einer Spur jeweils exakt zur Hälfte, so kann im detekierten Abtaststrahl, beispielsweise durch separates Erfassen der Randstrahlen, deren reflektierte Intensität getrennt ausgewertet und ein sehr genaues Positionsregelsignal erzeugt werden. Zum Erzeugen der drei parallel verlaufenden Strahlen des Dreistrahltracksystems wird in der Lichtquelle für den Abtaststrahl in herkömmlicher Weise ein Beugungsgitter zum Erzeugen von leicht versetzt angeordneten virtuellen Lichtquellpunkten integriert.

Sämtliche zuvor beispielhaft angeführten Ausführungsformen der Erfindung beruhen darauf, dass durch die optischen Eigenschaften der Strahlführungsmaske der Abtaststrahl derart beeinflusst wird, dass sich daraus eine gegebenenfalls auftretende Abweichung von einer vorgegebenen Spur nachweisen und in ein Regelsignal für die Positionierung des Abtaststrahls und des Schreibstrahls umwandeln lässt.

Eine weitere Verbesserung besteht darin, dass während des Abscannens der Spuren eine Richtungsinformation erzeugt wird, um ein unbeabsichtigtes Rückwärtsscannen des Abtaststrahls auf der Oberfläche der Strahlführungsmaske nachweisen zu können. Dadurch kann das Schreiben des Hologramms auch unter nicht erschütterungsfreien Bedingungen zuverlässig erfolgen. Die Richtungsinformation wird insbesondere dadurch erzeugt, dass entlang der Spuren zwei um jeweils 90° versetzte periodische Strukturen mit unterschiedlichen optischen Eigenschaften ausgebildet sind, so dass aus den von den periodischen Strukturen im detektierten Strahl erzeugten Signalanteilen ein Richtungssignal abgeleitet werden kann.

In weiter bevorzugter Weise wird mindestens an einem Der Enden jeder Spur eine Markierung vorgesehen, die eine Adressinformation enthält, aus der die Position der Spur innerhalb der Mehrzahl von Spuren abgeleitet wird. Somit erfolgt auch während des Abtastvorgangs eine Kontrolle über die Position der nachfolgend abzuscannenden Spur, die die Genauigkeit des Erzeugens des Hologramms verbessert.

Wie bereits zuvor erwähnt worden ist, sind für das Schreiben des digitalen Hologramms ein zeitliches Triggersignal und ein Intensitätssignal erforderlich. Dieses können auch unter Zuhilfenahme der Strahlführungsmaske erzeugt werden.

Dazu weisen in vorteilhafter Weise die Spuren eine periodische Abfolge von Abschnitten mit unterschiedlichen optischen Eigenschaften auf, aus denen ein Triggersignal zum Steuern der Intensität des Schreibstrahls abgeleitet wird. Im detektierten Abtaststrahl sind somit Intensitätsschwankungen enthalten, aus denen eine zeitliche Information zum Triggern des Schreibstrahls abgeleitet werden kann.

Bei einer anderen Ausführungsform ist mindestens an einem der Enden jeder Spur eine Markierung vorgesehen, aus der ein Startsignal bzw. ein Stopsignal abgeleitet wird. Somit kann zu Beginn des Abtastens einer Spur ein zeitliches Signal erzeugt werden, mit dem eine externe Triggerung mit einer vorgegebenen Frequenz ausgelöst wird. Es wird also während des Scannens entlang einer der Spuren beginnend mit dem Startsignal ein periodisches Triggersignal erzeugt, mit dem die Intensität des Schreibstrahls zeitlich gesteuert wird.

Weiterhin kann in vorteilhafter Weise vorgesehen sein, das Triggersignal mit einem Intensitätssteuersignal zu verknüpfen, mit dem die Intensität des Schreibstrahls gesteuert wird. Dieses Intensitätssteuersignal kann entweder aus der Intensität des Abtaststrahls abgeleitet oder extern erzeugt werden. Für die letztere Alternative wird das Intensitätssteuersignal in einem Speichermittel extern gespeichert und mit Hilfe der Position der Spur und des Zeitpunktes innerhalb des Abtastens der Spur der zugehörige Intensitätswert ermittelt.

Bei der Ableitung des Intensitätssteuersignals aus der Intensität des Abtaststrahls selbst sind in der Spur der Strahlführungsmaske optische Informationen enthalten, die die Intensität des Abtaststrahls während des Abtastens der Spur variieren. Dieses kann durch unterschiedlich starke Reflexionseigenschaften verschiedener Abschnitte der Spur oder durch in der Oberflächenstruktur enthaltene topographische Erhebungen oder Vertiefungen realisiert werden. So sind beispielsweise in einer als Rille ausgebildeten Spur eine Reihe von Erhebungen angeordnet.

In bevorzugter Weise wird als Strahlführungsmaske ein räumlicher Strahlmodulator (spatial light modulator - SLM) verwendet, mit dem eine zeitlich variabel einstellbare Strahlführungsmaske realisieren läßt.

Das oben aufgezeigte technische Problem wird gemäß einer zweiten Lehre der vorliegenden Erfindung durch einen Lithographen mit den Merkmalen des Anspruches 19 gelöst.

Die zuvor beschriebene Funktionsweise der vorliegenden Erfindung sowie deren bevorzugte Ausgestaltungen können auch in vorteilhafter Weise bei einem scannenden, insbesondere konfokalen Mikroskop eingesetzt werden. Bei einem derartigen Mikroskop wird die zu untersuchende Oberfläche mit einem Lichtstrahl abgetastet bzw. beobachtet und die reflektierte Lichtintensität wird gemessen. Während des Abtastens der Oberfläche wird dann das Bild aus den gemessenen Intensitäten des reflektierten Lichts zusammengesetzt. Die Oberfläche wird also in einem Raster abgetastet, wie es zuvor beschrieben worden ist.

Vorliegend wird dazu im Strahlengang des reflektierten Strahls vor oder bevorzugt hinter dem Objektiv ein Strahlteiler angeordnet, um die reflektierte Strahlung auf einen optischen Sensor zu leiten. Dieser misst die reflektierte Intensität.

Mit einem derartigen Mikroskop werden das technische Problem gelöst, eine Oberfläche möglichst schnell und mit geringem Aufwand zu beobachten bzw. abzutasten. Dieses steht im Einklang mit der dem zuvor beschriebenen Lithographen zugrundeliegenden technische Problem. Die zuvor für den Lithographen beschriebenen Vorteile werden ebenfalls bei einem derartigen Mikroskop erreicht.

Nachfolgend wird die Erfindung anhand von Ausführungsbeispielen mit Bezug auf die beigefügte Zeichnung näher erläutert wird. In der Zeichnung zeigen
- Fig. 1: ein Ausführungsbeispiel eines erfindungsgemäßen Lithographen,
- Fig. 2: ein erstes Ausführungsbeispiel einer Strahlführungsmaske,
- Fig. 3: ein zweites Ausführungsbeispiel einer Strahlführungsmaske und
- Fig. 4: ein erfindungsgemäßes Mikroskop mit einem Aufbau, der im wesentlichen dem Aufbau des in Fig. 1 dargestellten Lithographen entspricht.

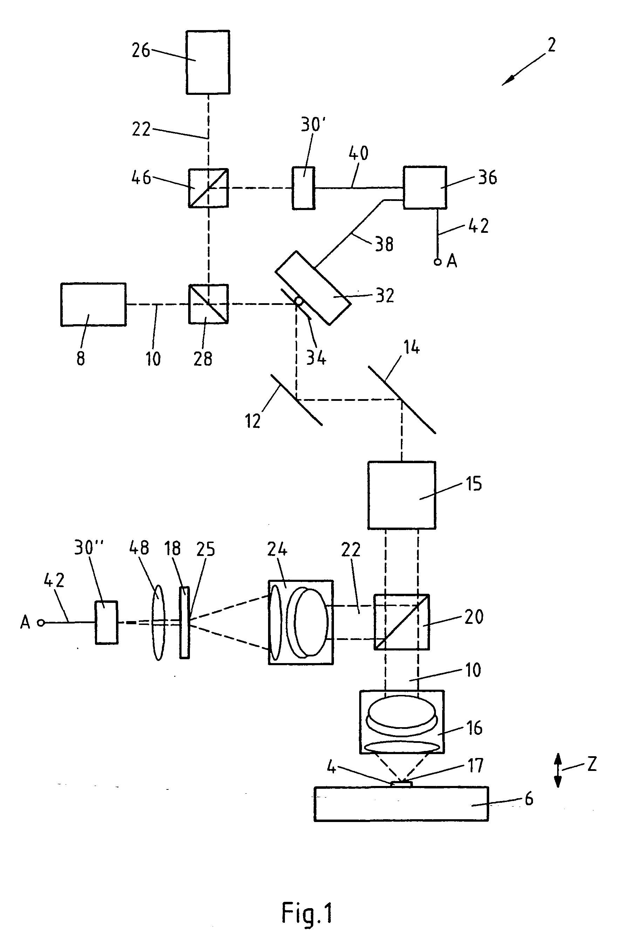

Fig. 1 zeigt ein Ausführungsbeispiel eines erfindungsgemäßen Lithographen 2 zum Herstellen digitaler Hologramme in einem Speichermedium 4, das auf einem Träger 6 angeordnet ist. Eine Lichtquelle 8 zum Erzeugen eines Schreibstrahls 10 weist bevorzugt einen Laser oder eine Laserdiode auf, so daß der Schreibstrahl 10 als Laserstrahl ausgebildet ist.

Der Lithograph 2 weist weiterhin Antriebsmittel zum zweidimensionalen Bewegen des Schreibstrahls 10 relativ zum Speichermedium 4 auf, die als galvanisch angetriebene Scanspiegel 12 und 14 ausgebildet sind und in zwei im wesentlichen orthogonal zueinander ausgerichtete x- und y-Richtungen den Schreibstrahl ablenken. Die x-Richtung verläuft beispielsweise in der Bildebene der Fig. 1 und die y-Richtung verläuft in einer Ebene senkrecht zur Bildebene. Die Spiegel 12 und 14 stellen also eine x/y-Scanspiegelanordnung dar. Anstelle eines der beiden oder beider galvanischen Scanspiegel können auch drehbare Polygonspiegel eingesetzt werden.

Optional ist weiterhin ein Strahlaufweiter bzw. Kollimator 15 im Strahlengang hinter den Scanspiegeln 12 und 14 angeordnet, um einen aufgeweiteten Schreibstrahl 10 zu erzeugen.

Ein erstes Objektiv 16 fokussiert den Schreibstrahl 10 auf das zu beschreibende Speichermedium 4, so daß im Fokus 17 in Abhängigkeit von der gebündelten Intensität des Schreibstrahls 10 die optische Eigenschaft des Speichermediums 4 verändert wird oder unverändert bleibt.

Erfindungsgemäß ist eine zweidimensionale Strahlführungsmaske 18 vorgesehen, auf die ein durch einen Strahlteiler 20 aus dem Schreibstrahl 10 ausgekoppelter Abtaststrahl 22 mit einem zweiten Objektiv 24 in einem Fokus 25 fokussiert wird.

Der Abtaststrahl 22 wird durch eine zweite Lichtquelle 26 erzeugt, der mit einem Strahlteiler 28 in den Strahlengang des Schreibstrahls 10 vor dem ersten Scanspiegel 12 eingekoppelt wird. Der Abtaststrahl 22 weist eine vom Schreibstrahl 10 abweichende Wellenlänge oder Polarisation auf, so daß der Strahlteiler 28 als dichroitischer oder polarisierender Strahlteiler ausgebildet ist. Der Strahlteiler 20 ist dann entsprechend dichroitisch oder polarisierend ausgebildet, um den Abtaststrahl 22 aus dem gemeinsamen Strahlengang auszukoppeln.

Der Abtaststrahl 22 ist also unabhängig von der Intensitätsmodulation des Schreibstrahls 10, so dass dieser auch ausgeschaltet, also mit einer Intensität gleich Null eingestellt werden kann.

Dagegen ist es auch möglich, den Abtaststrahl 22 als Teilstrahl aus dem Schreibstrahl auszukoppeln, ohne dass der Abtaststrahl 22 von einer separaten Lichtquelle erzeugt werden muß. Die Strahlteiler 20 und 28 sind dann als teildurchlässige Strahlteiler ausgebildet.

Beide Objektive 16 und 24 weisen jeweils drei Linsen eines fokussierenden Linsensystems auf. Jedoch kommt es auf die genaue Ausgestaltung der Objektive 16 und 24 nicht an. Die Objektive 16 und 24 können dabei vorzugsweise so ausgebildet sein, dass deren Winkelablenkungen in x-/y-Richtung linear voneinander abhängen, wodurch eine lineare Kopplung zwischen den Bewegungen der Foki 17 und 25 entsteht.

Wie sich aus dem Aufbau des Lithographen 2 gemäß Fig. 1 ergibt, bewegen die Antriebsmittel, also die Scanspiegel 12 und 14 nicht nur den Schreibstrahl 10, sondern auch den Abtaststrahl 22. Denn der Strahlteiler 20 ist im Strahlengang des Schreibstrahls 10 hinter den Scanspiegeln 12 und 14 angeordnet. Somit bewegt sich der Abtaststrahl 22 in gleicher Weise zweidimensional wie der Schreibstrahl 10, so daß der Abtaststrahl 22 relativ zur Oberfläche der Strahlführungsmaske 18 bewegt wird. Daraus ergibt sich, dass die Bewegung des Abtaststrahls 22 mit der Bewegung des Schreibstrahls 10 gekoppelt ist.

Weiterhin ist ein Detektor 30' oder ein Detektor 30" alternativ oder kumulativ zum Aufnehmen des durch die optischen Eigenschaften der jeweiligen Spur der Strahlführungsmaske 18 in der Intensität variierten Abtaststrahls 22 vorgesehen. Die zwei verschiedenen Positionen sind in Fig. 1 dargestellt. Die Funktionsweise in den beiden Positionen ähnlich und wird weiter unten näher erläutert.

Wie weiterhin Fig. 1 zeigt, ist ein Aktuator 32 mit einem Ablenkspiegel 34 zum Nachführen des Schreibstrahls 10 und des Abtaststrahls 22 im Strahlengang angeordnet ist. Die Position kann dabei an einer beliebigen Stelle im Strahlengang zwischen dem Strahlteiler 28 und dem Strahlteiler 20 angeordnet sein.

Weiterhin sind Regelungsmittel 36 zum Erzeugen eines Positionsregelsignals vorgesehen, mit dem der Aktuator 32 gesteuert wird. Dazu ist eine Steuerleitung 38 vorgesehen. Als Eingangssignal erhält der Aktuator 32 vom Detektor 30' über die Leitung 40 und vom Detektor 30" über die Leitung 42 (in Fig. 1 bei den Punkten A unterbrochen dargestellt) das Istsignal, mit dem die Regelung der Strahlführung durchgeführt wird.

Weiterhin erzeugen die Regelungsmittel 36 ein Intensitätssteuersignal, das über eine nicht dargestellte Leitung zum Steuern der Intensität des Schreibstrahls 10 auf die Lichtquelle 8 übertragen wird. Die Steuermittel 36 sind als Computer ausgebildet. Durch das übermittelte Intensitätssteuersignal wird der Schreibstrahl 10 in Abhängigkeit von der Position des Fokus 25 des Abtaststrahls 22 auf der Strahlführungsmaske 18, die mit der Position des Fokus 17 des Schreibstrahls 10 auf dem Speichermedium 4 gekoppelt ist, moduliert.

Mit anderen Worten wird der Schreibstrahl 10 für ein Schreiben von Hologrammpunkten mit zwei oder mehr verschiedenen Intensitätswerten eingestellt. Bei einem binären Schreiben wird die Intensität zwischen zwei verschiedenen Werten hin-und hergeschaltet, je nach dem, ob ein Punkt geschrieben werden soll oder nicht. Ebenso ist ein Schreiben von Hologrammpunkten mit einer Grauwertabstufung möglich und sinnvoll.

Wenn jedoch, wie oben beschrieben wurde, der Abtaststrahl 22 als Teilstrahl des Schreibstrahls 10 ausgekoppelt wird, ohne dass es einer separaten Lichtquelle bedarf, dann ist es für die Erfassung des Fokus 25 auf der Strahlführungsmaske 18 allerdings erforderlich, dass der niedrigere oder niedrigste Intensitätswert des Schreibstrahls 10 nicht gleich Null ist. Dadurch wird gewährleistet, dass der Abtaststrahl 22 immer eine Mindestintensität für ein Erzeugen eines Positionsregelsignals aufweist.

Weiterhin wird bei dem in Fig. 1 dargestellten Aufbau des Lithographen 2 ein längenbezogenes Übersetzungsverhältnis zwischen der Bewegung des Schreibstrahls 10 auf dem Speichermedium 4 des Abtaststrahls 22 auf der Strahlführungsmaske 18 vorgegeben. Dieses wird durch unterschiedliche Brennweiten der beiden Objektive 14 und 26 realisiert. Ist beispielsweise die Brennweite des ersten Objektives 16 um einen Faktor 10 kleiner als die Brennweite des zweiten Objektivs 24, so ist die Bewegung des Fokus 25 des Abtaststrahls 22 auf der Strahlführungsmaske 18 um den gleichen Faktor 10 mal größer als die Bewegung des Fokus 17 auf der Oberfläche des Speichermediums 4. In der Fig. 1 ist aus Platzgründen lediglich ein Brennweitenverhältnis von ca. 2 dargestellt. Dieses verdeutlich aber, dass es nicht auf ein bestimmtes Verhältnis bei der vorliegenden Ausgestaltung der Erfindung ankommt.

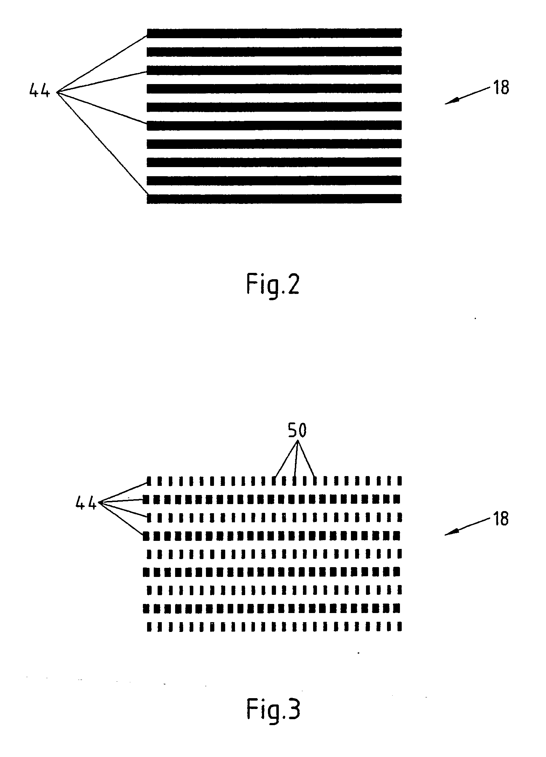

Wie die Fig. 2 und 3 zeigen, weist die Strahlführungsmaske 18 eine Mehrzahl von Spuren 44 auf.

Diese sind in einem orthogonalen Raster angeordnet und weisen im wesentlichen gleiche Abstände zueinander auf. Ganz allgemein können die Spuren 44 aber in einer vorgegebenen Anordnung vorliegen, bei der die Spuren selbst eine beliebig verlaufende, also auch gekrümmte Form und variierende Abstände zueinander aufweisen. Denn die Anordnung der Spuren 44 gibt das zu schreibende Punktraster des digitalen Hologramms wieder.

Weiterhin können, wie oben ausführlich dargelegt worden ist, die Spuren 44 der Strahlführungsmaske 18 Markierungen als Träger von Spurpositionsinformationen aufweisen. Darüber hiaus können die Spuren 44 der Strahlführungsmaske 18 Markierungen als Träger eines Startsignal und ggf. eines Stopsignals aufweisen.

Die Strahlführungsmaske 18 kann eine Oberfläche mit unterschiedlichen Reflexionseigenschaften aufweisen. Dazu ist die Strahlführungsmaske 18 zu einem Teil mit einer reflektierenden Schicht versehen. Ebenso können die unterschiedlichen Reflexionseigenschaften als verschiedenen Färbungen des Materials der Strahlführungsmaske ausgebildet sein. Ebenso können unterschiedliche refraktive Eigenschaften des Materials die verschiedenen Reflexionseigenschaften bewirken. Schließlich kann die Strahlführungsmaske als räumlicher Strahlmodulator (spatial light modulator - SLM) ausgebildet sein. Dadurch wird in vorteilhafter Weise eine zeitlich veränderbare Strahlführungsmaske realisiert.

Weiterhin kann die Strahlführungsmaske 18 eine Oberfläche mit einer topographischen Oberflächenstruktur aufweisen, an der der Abtaststrahl 22 beugend reflektiert wird.

Für beide Ausgestaltungen der Strahlführungsmske, die den Abtaststrahl in Richtung zurück auf die Lichtquelle 26 refklektiert, ist im Strahlengang des Abtaststrahls 22 in Strahlrichtung vor dem Aktuator 32, der die Strahlen 10 und 22 nachführt, ein Strahlauskoppler 46 vorgesehen ist. Dieser leitet den reflektierten Abtaststrahl 22 auf den Detektor 30'. Dort wird das Detektionssignal als Regelsignal für die Regelungsmittel 36 erzeugt.

Weiterhin kann die Strahlführungsmaske 18 eine Oberfläche mit unterschiedlichen Transmissionseigenschaften aufweisen. Somit wird der Abtaststrahl 22 unterschiedlich stark durchgelassen. Der durchgelassene Anteil des Abtaststrahls 22 wird mit einer Optik 48 auf die Oberfläche des Detektors 30' fokussiert. Dort wird dann das Regelsignal für die Regelungsmittel 36 erzeugt, das über die Leitung 42 übertraqen wird.

Auch in diesem Fall kann das Material der Strahlführungsmaske 18 in verschiedener Weise ausgebildet sein. Die unterschiedlichen Transmissionseigenschaften können durch unterschiedliche Einfärbungen des an sich lichtdurchlässigen Materials erzeugt werden. Die Strahlführungsmaske 18 kann aber auch in diesem Fall als räumlicher Strahlmodulator (spatial light modulator - SLM) ausgebildet sein. Dadurch wird in vorteilhafter Weise eine zeitlich veränderbare transmittierende Strahlführungsmaske realisiert.

Die Regelungsmittel 36 zum Erzeugen eines Positionsregelsignals weisen Computermittel auf, die mit den Detektoren 30' und/oder 30'' verbunden sind. Diese vergleichen das von den Detektoren aufgenommen Regelsignal mit Sollwerten, so dass das Steuersignal für den Aktuator 32 in Abhängigkeit vom Regelsignal erzeugt wird.

Die Regelungsmittel 36 werden auch zum Erzeugen eines zeitlichen Triggersignals eingesetzt. Dazu werden die Startsignale aus entsprechenden Markierungen an den Enden der Spuren 44 verwendet, um nachfolgend ein Triggersignal mit vorgegebener Taktrate zu erzeugen, mit der die Intensität der Lichtquelle 8 gesteuert wird.

Darüber hinaus können die Spuren selber Triggersignale aufweisen, wie in Fig. 3 dargestellt ist. Dazu ist jede Spur 44 in eine Abfolge von Abschnitten 50 mit unterschiedlichen optischen Eigenschaften unterteilt, so dass aus den vom Detektor 30' bzw. 30" gemessenen Intensitäten des Abtaststrahls 22 das Triggersignal abgeleitet werden kann.

Die Regelungsmittel 36 können ebenfalls zum Erzeugen eines Intensitätssteuersignals eingesetzt werden. Dazu weisen die Regelungsmittel 36 Speichermittel auf, in denen zu den vorgegebenen Positionen entlang der Spuren 44 Intensitätswerte abgelegt sind, die jeweils ausgelesen und zum Steuern der Intensität der Lichtquelle 8 eingesetzt werden.

Die unterschiedlichen Intensitäten können aber auch in den einzelnen in Fig. 3 dargestellten Abschnitten 50 enthalten sein, die sich somit dem von den Detektoren 30' bzw. 30" nachgewiesenen Signal ableiten lassen.

Ein weiteres Merkmal der zuvor beschriebenen Ausgestaltungen des Lithographen besteht darin, dass der Abstand zwischen dem Speichermedium 4 und dem Objektiv 16 in Fig. 1 variabel einstellbar ist. Dieses ist mit einem mit "Z" bezeichneten Doppelpfeil gekennzeichnet. Für ein Verstellen des Abstandes in z-Richtung sind in den Figuren nicht dargestellte Mittel vorgesehen. Dieses können jegliche linearen Verstellmittel sein, die motorisch oder per Hand angetrieben sein können. Durch ein Verstellen des Abstandes kann die Lage des Fokus im Speichermedium 4 in verschiedenen Tiefen angeordnet werden, ebenso ist eine Justierung des Fokus bei unterschiedlich dicken Speichermedien 4 möglich. Schließlich können mindestens zwei digitale Hologramme in verschiedenen Ebenen innerhalb des Speichermediums 4 eingeschrieben werden, um sogenannte Mehrschichthologramme zu erzeugen.

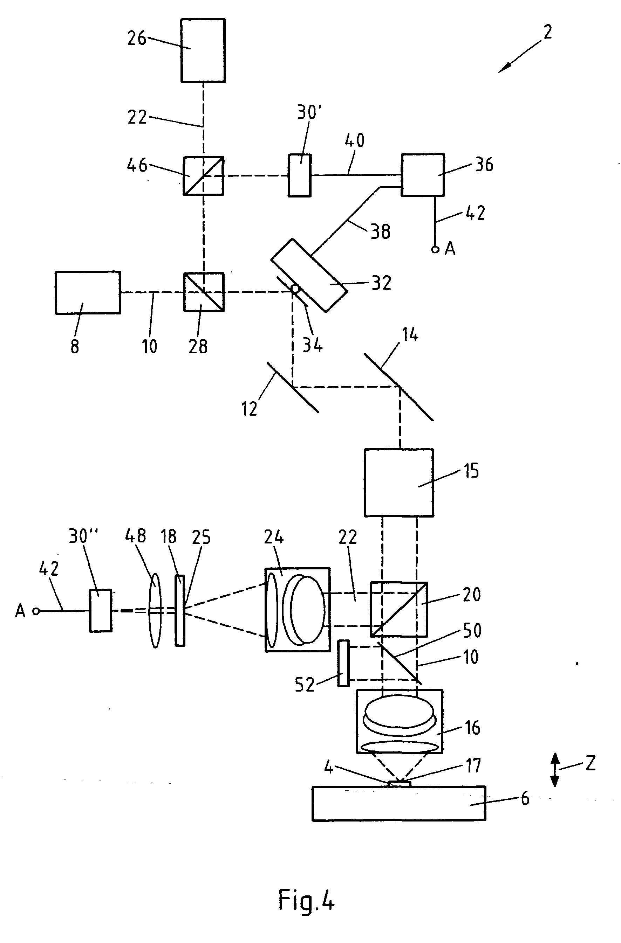

In Fig. 4 ist ein erfindungsgemäßes Mikroskop dargestellt, das in seinem Aufbau dem in Fig. 1 dargestellten Lithographen entspricht. Daher bezeichnen gleiche Bezugszeichen gleiche Bauteile wie im Zusammenhang mit Fig. 1 beschrieben worden sind, auch wenn im einzelne andere Bezeichnungen verwendet werden, die den Unterschied zwischen Schreiben und Beobachten kennzeichnen.

Zusätzlich zum in Fig. 1 dargestellten Aufbau ist im Strahlengang des von der Oberfläche reflektierten Lichtes hinter, also oberhalb des Objektivs 16 eine Umlenkebene 50 angeordnet. Diese kann durch einen halbdurchlässigen Spiegel oder einen Strahlteiler verwirklicht sein und beeinflusst nicht oder nur unwesentlich den Beobachtungsstrahl.

Die Umlenkebene 50 lenkt den reflektierten Strahl seitlich, in Fig. 4 nach links ab, so dass dieser auf einen Photosensor 52 trifft, der die Intensität des reflektierten Lichtes misst.

Durch das Verändern des Beobachtungsstrahls 10 relativ zum zu mikroskopierenden Objekt 4 wird dann die Oberfläche abgetastet und punktweise die Reflektivität gemessen. Somit kann eine Abbildung der abgetasteten Oberfläche zusammengesetzt werden.

Wird nun der von der Lichtquelle 8 emittierte Lichtstrahl, der bei dem Mikroskop als Beobachtungsstrahl bezeichnet werden kann, mit im wesentlichen gleich starker Intensität erzeugt, so ist die gemessene Intensität des reflektierten Strahls ein Maß für die Reflektivität der abgetasteten Oberfläche.

## Patentansprüche

1. Verfahren zum Herstellen digitaler Hologramme in einem Speichermedium (4),
- bei dem ein Schreibstrahl (10) auf das Speichermedium (4) fokussiert und zweidimensional relativ zum Speichermedium (4) bewegt wird,
- bei dem ein Abtaststrahl (22) auf eine eine Mehrzahl von Spuren (44) aufweisende Strahlführungsmaske (18) fokussiert und zweidimensional relativ zur Strahlführungsmaske (18) bewegt wird, wobei die Bewegung des Abtaststrahls (22) mit der Bewegung des Schreibstrahls (10) gekoppelt wird,
- bei dem dann, wenn die Position des Abtaststrahls (22) während der Bewegung entlang der abzutastenden Spur (44) der Strahlführungsmaske (18) von der abgetasteten Spur (44) um einen vorgegebenen Wert abweicht, ein Positionsregelsignal erzeugt wird,
- bei dem mit Hilfe des Positionsregelsignals die Position des Schreibstrahls (10) auf dem Speichermedium (4) geregelt wird, und
- bei dem das Hologramm durch punktweises Einbringen von Strahlungsenergie geschrieben wird, wobei die Intensität des Schreibstrahls (10) in Abhängigkeit von der Position des Schreibstrahls (10) auf dem Speichermedium (4) gesteuert wird.

2. Verfahren nach Anspruch 1,
bei dem der Abtaststrahl in einem vorgegebenen Bewegungsverhältnis zum Schreibstrahl bewegt wird.

3. Verfahren nach Anspruch 1 oder 2,
bei dem der Abtaststrahl auf eine Größe fokussiert wird, die maximal der Spurabmessung der Strahlführungsmaske entspricht.

4. Verfahren nach einem der Ansprüche 1 bis 3,
bei dem die Spuren der Strahlführungsmaske eine von der umgebenden Oberfläche seitlich neben den Spuren unterschiedliche Reflektivität aufweisen und bei dem der von der Oberfläche der Strahlführungsmaske reflektierte Strahl detektiert wird, wobei aus der Intensitätsverteilung des reflektierten Strahls das Positionsregelsignal abgeleitet wird.

5. Verfahren nach einem der Ansprüche 1 bis 3,
bei dem die Spuren der Strahlführungsmaske eine von der umgebenden Oberfläche seitlich neben den Spuren unterschiedliche Transmissionseigenschaft aufweisen und bei dem der durch die Strahlführungsmaske transmittierte Strahl detektiert wird, wobei aus der Intensitätsverteilung des transmittierten Strahls das Positionsregelsignal abgeleitet wird.

6. Verfahren nach einem der Ansprüche 1 bis 3,
bei dem die Spuren der Strahlführungsmaske eine Oberflächenstruktur aufweisen und bei dem der von der Oberfläche der Strahlführungsmaske reflektierte Strahl detektiert wird, wobei aus der Intensitätsverteilung des reflektierten Strahls das Positionsregelsignal abgeleitet wird.

7. Verfahren nach einem der Ansprüche 1 bis 6,
bei dem der Abtaststrahl drei nebeneinander verlaufende Teilstrahlen aufweist und bei dem zusätzlich zum mittleren Strahl aus den Intensitäten der beiden Randstrahlen das Positionsregelsignal abgeleitet wird.

8. Verfahren nach einem der Ansprüche 1 bis 7,
bei dem während des Scannens des Abtaststrahls entlang der Spur der Strahlführungsmaske ein Richtungssignal erzeugt wird.

9. Verfahren nach Anspruch 8,
bei dem entlang der Spuren zwei um jeweils eine vorgegebene Phase, vorzugsweise um 90° versetzte periodische Strukturen mit unterschiedlichen optischen Eigenschaften ausgebildet sind und bei dem aus den von den periodischen Strukturen im detektierten Strahl erzeugten Signalanteilen ein Richtungssignal abgeleitet wird.

10. Verfahren nach einem der Ansprüche 1 bis 10,
bei dem mindestens an einem der Enden jeder Spur eine Markierung vorgesehen ist, aus der ein Startsignal bzw. ein Stopsignal abgeleitet wird.

11. Verfahren nach Anspruch 10,
bei dem die Markierung eine Adressinformation enthält.

12. Verfahren nach Anspruch 11,
bei dem aus der Adressinformation die Position der Spur innerhalb der Mehrzahl von Spuren abgeleitet wird.

13. Verfahren nach einem der Ansprüche 10 bis 12,
bei dem die Spuren eine periodische Abfolge von Abschnitten mit unterschiedlichen optischen Eigenschaften aufweisen, aus denen ein Triggersignal zum Steuern der Intensität des Schreibstrahls abgeleitet wird.

14. Verfahren nach Anspruch 13,
bei dem während des Scannens entlang einer der Spuren beginnend mit dem Startsignal ein periodisches Triggersignal erzeugt wird, mit dem die Intensität des Schreibstrahls zeitlich gesteuert wird.

15. Verfahren nach Anspruch 14,
bei dem das Triggersignal mit einem Intensitätssteuersignal verknüpft wird, mit dem die Intensität des Schreibstrahls in ihrer Größe gesteuert wird.

16. Verfahren nach Anspruch 15,
bei dem das Intensitätssteuersignal aus der Intensität des Abtaststrahls abgeleitet wird.

17. Verfahren nach Anspruch 16,
bei dem das Intensitätssteuersignal in einem Speichermittel extern gespeichert wird und mit Hilfe der Position der Spur und des Zeitpunktes innerhalb des Abtastens der Spur der zugehörige Intensitätswert ermittelt wird.

18. Verfahren nach einem der Ansprüche 1 bis 17,
bei dem der Abstand zwischen einem ersten Objektiv zum Fokussieren des Schreibstrahls und dem Speichermedium für ein Schreiben in verschiedenen Tiefen innerhalb des Speichermediums eingestellt wird.

19. Lithograph zum Herstellen digitaler Hologramme in einem Speichermedium (4), insbesondere zum Durchführen eines Verfahrens nach einem der Ansprüche 1 bis 15,
- mit einer Lichtquelle (8) zum Erzeugen eines Schreibstrahls (10),
- mit Antriebsmitteln (12,14) zum zweidimensionalen Bewegen des Schreibstrahls (10) relativ zum Speichermedium (4) und
- mit einem ersten Objektiv (16) zum Fokussieren des Schreibstrahls (10) auf das zu beschreibende Speichermedium (4),
- mit einer zweidimensionalen Strahlführungsmaske (18),
- mit Mitteln (20) zum Erzeugen eines Abtaststrahls (22),
- wobei die Antriebsmittel (12,14) zum Bewegen des Abtaststrahls (22) relativ zur Oberfläche der Strahlführungsmaske (18) ausgelegt sind und die Bewegung des Abtaststrahls (22,22') mit der Bewegung des Schreibstrahls (10) gekoppelt ist,
- mit einem Detektor (30',30") zum Aufnehmen des durch die Strahlführungsmaske (18) intensitätsvariierten Abtaststrahls, und
- mit Mitteln (36) zum Erzeugen eines Positionsregelsiginals,
**dadurch gekennzeichnet,**
- **dass** ein zweites Objektiv (24) zum Fokussieren des Abtaststrahls (22,22') auf die Strahlführungsmaske (18) vorgesehen ist,
- **dass** die Strahlführungsmaske (18) eine Mehrzahl von Spuren (44) aufweist und die Antriebsmittel zum zweidimensionalen Bewegen des Abtaststrahls (22) entlang einer dieser Spuren ausgelegt sind, und
- **dass** Mittel (32,34) zum Nachführen des Schreibstrahls (10) und des Abtaststrahls (22) vorgesehen sind.

20. Lithograph nach Anspruch 19,
**dadurch gekennzeichnet,**
**dass** die Mittel (36) zum Erzeugen des Positionsregelsignals zum Steuern der Intensität des Schreibstrahls (10) mit der Strahlführungsmaske (18) ausgelegt sind.

21. Lithograph nach Anspruch 19 oder 20,
**dadurch gekennzeichnet,**
**dass** die Mittel zum Nachführen des Schreibstrahls (10) und des Abtaststrahls (22) als x-/y-Aktuator (32, 34) ausgebildet ist.

22. Lithograph nach einem der Ansprüche 19 bis 21,
**dadurch gekennzeichnet,**
- **dass** die Antriebsmittel (12,14) als x/y-Scanspiegelanordnung zum Bewegen des Schreibstrahls (10) ausgebildet sind und
- **dass** die Mittel zum Erzeugen des Abtaststrahls (22) Mittel (20) zum Auskoppeln eines Teils des Schreibstrahls (10) als Abtaststrahl (22) im Strahlengang des Schreibstrahls (10) hinter den Antriebsmitteln (12,14) aufweisen.

23. Lithograph nach einem der Ansprüche 19 bis 21,
**dadurch gekennzeichnet,**
- **dass** die Mittel zum Erzeugen des Abtaststrahls (22)
- eine zweite Lichtquelle (26) zum Erzeugen eines Abtaststrahls (22) mit einer vom Schreibstrahl (10) abweichenden Wellenlänge oder Polarisation und
- Einkoppelmittel (28) zum Einkoppeln des Abtaststrahls (22) in den Strahlengang des Schreibstrahls (10) vor den Antriebsmitteln (12,14) aufweisen und
- **dass** die Mittel (20) zum Auskoppeln den Abtaststrahl (22) auskoppeln.

24. Lithograph nach einem der Ansprüche 19 bis 23,
**dadurch gekennzeichnet,**
**dass** ein längenbezogenes Übersetzungsverhältnis zwischen der Bewegung des Abtaststrahls (22) auf der Strahlführungsmaske (18) und des Schreibstrahls (10) auf dem Speichermedium (4) vorgegeben ist.

25. Lithograph nach Anspruch 24,
**dadurch gekennzeichnet,**
**dass** die Brennweite des zweiten Objektivs (24) um einen vorgegebenen Faktor größer als die Brennweite des ersten Objektivs (16) ist.

26. Lithograph nach einem der Ansprüche 19 bis 25,
**dadurch gekennzeichnet,**
**dass** die Spuren (44) in einem Raster, insbesondere orthogonalem Raster, angeordnet sind.

27. Lithograph nach einem der Ansprüche 19 bis 26,
**dadurch gekennzeichnet,**
**dass** die Strahlführungsmaske (18) eine Oberfläche mit unterschiedlichen Reflexionseigenschaften aufweist.

28. Lithograph nach Anspruch 27,
**dadurch gekennzeichnet,**
**dass** die Strahlführungsmaske (18) als räumlicher Strahlmodulator ausgebildet ist.

29. Lithograph nach einem der Ansprüche 19 bis 26,
**dadurch gekennzeichnet,**
**dass** die Strahlführungsmaske (18) eine Oberfläche mit einer topographischen Oberflächenstruktur aufweist, an der der Abtaststrahl reflektiert wird.

30. Lithograph nach einem der Ansprüche 27 bis 29,
**dadurch gekennzeichnet,**
**dass** im Strahlengang des Abtaststrahls (22) in Strahlrichtung vor dem Mittel (32,34) zum Nachführen der Strahlen (10,22) ein Strahlauskoppler (18) vorgesehen ist, der den reflektierten Abtaststrahl auf den Detektor (30',30") leitet.

31. Lithograph nach einem der Ansprüche 19 bis 26,
**dadurch gekennzeichnet,**
**dass** die Strahlführungsmaske (18) eine Oberfläche mit unterschiedlichen Transmissionseigenschaften aufweist.

32. Lithograph nach Anspruch 31,
**dadurch gekennzeichnet,**
**dass** die Strahlführungsmaske (18) als räumlicher Strahlmodulator ausgebildet ist.

33. Lithograph nach Anspruch 31 oder 32,
**dadurch gekennzeichnet,**
**dass** eine Fokussierungsoptik (48) zum Fokussieren der transmittierten Strahlung auf den Detektor (30',30") vorgesehen ist.

34. Lithograph nach einem der Ansprüche 19 bis 33,
**dadurch gekennzeichnet,**
**dass** die Spuren (44) der Strahlführungsmaske (18) Markierungen als Träger von Spurpositionsinformationen aufweisen.

35. Lithograph nach einem der Ansprüche 19 bis 34,
**dadurch gekennzeichnet,**
**dass** die Spuren (44) der Strahlführungsmaske (18) Markierungen als Träger eines Startsignal und ggf. eines Stopsignals aufweisen.

36. Lithograph nach einem der Ansprüche 19 bis 35,
**dadurch gekennzeichnet,**
**dass** die Regelungsmittel (36) zum Erzeugen eines Positionsregelsignals Computermittel und/oder Speichermittel aufweisen, die mit den Detektoren (30',30'') verbunden sind.

37. Lithograph nach einem der Ansprüche 19 bis 36,
**dadurch gekennzeichnet,**
**dass** die Regelungsmittel (36) zum Erzeugen eines Intensitätssteuersignals Computermittel und/oder Speichermittel aufweisen, die mit den Detektoren (30',30'') verbunden sind.

38. Lithograph nach einem der Ansprüche 19 bis 37,
**dadurch gekennzeichnet,**
**dass** Mittel zum Verstellen des Abstandes zwischen dem Speichermedium (4) und dem ersten Objektiv (16) vorgesehen sind.

39. Mikroskop zum Abtasten eines Objektes (4),
- mit einer Lichtquelle (8) zum Erzeugen eines Beobachtungsstrahls (10),
- mit Antriebsmitteln (12,14) zum zweidimensionalen Bewegen des Beobachtungsstrahls (10) relativ zum Objekt (4),
- mit einem ersten Objektiv (16) zum Fokussieren des Abtaststrahls (10) auf das Objekt (4),
- mit einer zweidimensionalen Strahlführungsmaske (18) mit einer Mehrzahl von Spuren,
- mit Mitteln (20) zum Erzeugen eines Abtaststrahls (22),
- mit einem zweiten Objektiv (24) zum Fokussieren des Abtaststrahls (22,22') auf die Strahlführungsmaske (18),
- wobei die Antriebsmittel (12,14) den Abtaststrahl (22) zweidimensional relativ zur Oberfläche der Strahlführungsmaske (18) entlang einer der Spuren bewegen, wobei die Bewegung des Abtaststrahls (22,22') mit der Bewegung des Beobachtungsstrahls (10) gekoppelt ist,
- mit einem Detektor (30',30") zum Aufnehmen des durch die optischen Eigenschaften der Spur (44) intensitätsvariierten Abtaststrahls,
- mit Mitteln (32,34) zum Nachführen des Beobachtungsstrahls (10) und des Abtaststrahls (22),
- mit Mitteln (26) zum Erzeugen eines Positionsregelsignals,
- mit einem Photosensor (52), und
- mit einer im Strahlengang des vom Objekt reflektierten Beobachtungsstrahls vor oder hinter dem ersten Objektiv (16) angeordneten Umlenkebene (50) zum Ablenken des vom Objekt reflektierten Beobachtungsstrahls auf den Photosensor (52).

## Claims

1. A method of producing digital holograms in a storage medium (4),
- in which a write beam (10) is focused onto the storage medium (4) and moved two-dimensionally relative to the storage medium (4),
- in which a scanning beam (22) is focused onto a beam-guiding mask (18) having a plurality of tracks (44) and moved two-dimensionally relative to the beam-guiding mask (18), the movement of the scanning beam (22) being coupled with the movement of the write beam (10),
- in which, a position control signal is generated when the position of the scanning beam (22) during the movement along the track (44) to be scanned on the beam-guiding mask (18) deviates from the scanned track (44) by a predefined value,
- in which the position of the write beam (10) on the storage medium (4) is controlled with the aid of the position control signal, and
- in which the hologram is written by introducing radiation energy point by point, the intensity of the write beam (10) being controlled as a function of the position of the write beam (10) on the storage medium (4).

2. The method as claimed in claim 1, in which the scanning beam is moved in a predefined movement relationship with the write beam.

3. The method as claimed in claim 1 or 2, in which the scanning beam is focused onto a size which corresponds at most to the track dimension of the beam-guiding mask.

4. The method as claimed in one of claims 1 to 3, in which the tracks of the beam-guiding mask have a different reflectance from the surrounding surface laterally beside the tracks, and in which the beam reflected from the surface of the beam-guiding mask is detected, the position control signal being derived from the intensity distribution of the reflected beam.

5. The method as claimed in one of claims 1 to 3, in which the tracks of the beam-guiding mask have a different transmission property from the surrounding surface laterally beside the tracks, and in which the beam transmitted through the beam-guiding mask is detected, the position control signal being derived from the intensity distribution of the transmitted beam.

6. The method as claimed in one of claims 1 to 3, in which the tracks of the beam-guiding mask have a surface structure and in which the beam reflected from the surface of the beam-guiding mask is detected, the position control signal being derived from the intensity distribution of the reflected beam.

7. The method as claimed in one of claims 1 to 6, in which the scanning beam has three part beams running beside one another and in which, in addition to the central beam, the position control signal is derived from the intensities of the two marginal beams.

8. The method as claimed in one of claims 1 to 7, in which, during the scanning of the scanning beam along the track of the beam-guiding mask, a direction signal is generated.

9. The method as claimed in claim 8, in which two periodic structures with different optical properties, offset by a predefined phase in each case, preferably by 90°, are formed along the tracks, and in which a direction signal is derived from the signal components produced in the detected beam by the periodic structures.

10. The method as claimed in one of claims 1 to 10, in which, at least at one of the ends of each track, a marking is provided from which a start signal or a stop signal is derived.

11. The method as claimed in claim 10, in which the marking contains address information.

12. The method as claimed in claim 11, in which the position of the track within the plurality of tracks is derived from the address information.

13. The method as claimed in one of claims 10 to 12, in which the tracks have a periodic sequence of sections with different optical properties, from which a trigger signal for controlling the intensity of the write beam is derived.

14. The method as claimed in claim 13, in which, during the scanning along one of the tracks, beginning with the start signal, a periodic trigger signal is generated with which the intensity of the write beam is time-controlled.

15. The method as claimed in claim 14, in which the trigger signal is linked with an intensity control signal, with which the intensity of the write beam is controlled in terms of its magnitude.

16. The method as claimed in claim 15, in which the intensity control signal is derived from the intensity of the scanning beam.

17. The method as claimed in claim 16, in which the intensity control signal is stored externally in a storage means and the associated intensity value is determined with the aid of the position of the track and the time within the scanning of the track.

18. The method as claimed in one of claims 1 to 17, in which the distance between a first objective for focusing the write beam (10) and the storage medium is adjusted for writing at different depths within the storage medium.

19. A lithograph for producing digital holograms in a storage medium (4), in particular for implementing a method as claimed in one of claims 1 to 15,
- having a light source (8) for producing a write beam (10),
- having drive means (12, 14) for the two-dimensional movement of the write beam (10) relative to the storage medium (4) and
- having a first objective (16) for focusing the write beam (10) onto the storage medium (4) to be written,
- having a two-dimensional beam-guiding mask (18),
- having means (20) of producing a scanning beam (22),
- wherein the drive means (12, 14) are designed for moving the scanning beam (22) relative to the surface of the beam-guiding mask (18) and the movement of the scanning beam (22, 22') is being coupled with the movement of the write beam (10),
- having a detector (30', 30") for picking up the scanning beam of which the intensity is varied by the beam-guiding mask (18),
- having means (36) for producing a position control signal,
**characterized**
- **in that** a second objective (24) for focusing the scanning beam (22, 22') onto the beam-guiding mask (18) is provided,
- **in that** the beam-guiding mask (18) has a plurality of tracks (44) and the drive means are designed for two-dimensionally moving the scanning beam (22) along one of said tracks (44), and
- **in that** means (32, 34) of tracking the write beam (10) and the scanning beam (22) are provided.

20. The lithograph as claimed in claim 19, **characterized in that** the means (36) are designed for generating of the position control signal for controlling the intensity of the write beam (10) with the beam-guiding mask (18).

21. The lithograph as claimed in claim 19 or 20, **characterized in that** the means of tracking the write beam (10) and the scanning beam (22) is formed as an x/y actuator (32, 34).

22. The lithograph as claimed in one of claims 19 to 21,
**characterized**
- **in that** the drive means (12, 14) are formed as an x/y scanning mirror arrangement for moving the write beam (10) and
- **in that** the means of producing the scanning beam (22) have means (20) for coupling part of the write beam (10) out as a scanning beam (22) in the beam path of the write beam (10) behind the drive means (12, 14).

23. The lithograph as claimed in one of claims 19 to 21,
**characterized**
- **in that** the means of producing the scanning beam (22)
- have a second light source (26) for producing a scanning beam (22) with a wavelength or polarization differing from the write beam (10) and
- input coupling means (28) for coupling the scanning beam (22) into the beam path of the write beam (10) in front of the drive means (12, 14) and
- **in that** the output coupling means (20) couple out the scanning beam (22).

24. The lithograph as claimed in one of claims 19 to 23, **characterized in that** a length-based step-up ratio between the movement of the scanning beam (22) on the beam-guiding mask (18) and of the write beam (10) on the storage medium (4) is predefined.

25. The lithograph as claimed in claim 24, **characterized in that** the focal length of the second.objective (24) is greater by a predefined factor than the focal length of the first objective (16).

26. The lithograph as claimed in one of claims 19 to 25, **characterized in that** the tracks (44) are arranged in a pattern, in particular an orthogonal pattern.

27. The lithograph as claimed in one of claims 19 or 26, **characterized in that** the beam-guiding mask (18) has a surface with different reflective properties.

28. The lithograph as claimed in claim 27, **characterized in that** the beam-guiding mask (18) is formed as a spatial beam modulator.

29. The lithograph as claimed in one of claims 19 or 26, **characterized in that** the beam-guiding mask (18) has a surface with a topographical surface structure, at which the scanning beam is reflected.

30. The lithograph as claimed in one of claims 27 to 29, **characterized in that** a beam output coupler (18), which leads the reflected scanning beam to the detector (30', 30"), is provided in the beam path of the scanning beam (22), in front in the beam direction of the means (32, 34) of tracking the beams (10, 22).

31. The lithograph as claimed in one of claims 19 or 26, **characterized in that** the beam-guiding mask (18) has a surface with different transmission properties.

32. The lithograph as claimed in claim 31, **characterized in that** the beam-guiding mask (18) is formed as a spatial light modulator.

33. The lithograph as claimed in claim 31 or 32, **characterized in that** focusing optics (48) are provided for focusing the transmitted radiation onto the detector (30', 30").

34. The lithograph as claimed in one of claims 19 to 33, **characterized in that** the tracks (44) of the beam-guiding mask (18) have markings as carriers of track position information.

35. The lithograph as claimed in one of claims 19 to 34, **characterized in that** the tracks (44) of the beam-guiding mask (18) have markings as carriers of a start signal and possibly a stop signal.

36. The lithograph as claimed in one of claims 19 to 35, **characterized in that** the control means (36) for producing a position control signal have computer means and/or storage means, which are connected to the detectors (30', 30").

37. The lithograph as claimed in one of claims 19 to 36, **characterized in that** the control means (36) for producing an intensity control signal have computer means and/or storage means, which are connected to the detectors (30', 30").

38. The lithograph as claimed in one of claims 19 to 37, **characterized in that** means of adjusting the distance between the storage medium (4) and the first objective (16) are provided.

39. A microscope for scanning an object (4),
- having a light source (8) for producing an observation beam (10),
- having drive means (12, 14) for the two-dimensional movement of the observation beam (10) relative to the object (4) and
- having a first objective (16) for focusing the scanning beam (10) onto the object (4),
- having a two-dimensional beam-guiding mask (18) having a plurality of tracks,
- having means (20) of producing a scanning beam (22),
- having a second objective (24) for focusing the scanning beam (22, 22') onto the beam-guiding mask (18),
- wherein the drive means (12, 14) move the scanning beam (22) two-dimensionally relative to the surface of the beam-guiding mask (18), the movement of the scanning beam (22, 22') being coupled with the movement of the observation beam (10),
- having a detector (30', 30") to pick up the scanning beam of which the intensity is varied by the optical properties of the track (44),
- having means (32, 34) of tracking the observation beam (10) and the scanning beam (22),
- having means (26) for producing a position control signal,
- having a photo sensor (52), and
- having a deflection plane (50) arranged in the beam path of the observation beam reflected from the object in front or behind the first objective (16) for deflection of the observation beam reflected from the object to the photo sensor (52).

## Revendications

1. Procédé de fabrication d'hologrammes numériques dans un support d'enregistrement (4),
- dans lequel un faisceau d'écriture (10) est focalisé sur le support d'enregistrement (4) et est déplacé dans deux dimensions par rapport au support d'enregistrement (4),
- dans lequel un faisceau de balayage (22) est focalisé sur un masque de guidage de faisceau (18) présentant une pluralité de pistes (44) et est déplacé dans deux dimensions par rapport au masque de guidage de faisceau (18), le déplacement du faisceau de balayage (22) étant couplé au déplacement du faisceau d'écriture (10),
- dans lequel, ensuite, lorsque la position du faisceau de balayage (22) au cours du déplacement le long de la piste à balayer du masque de guidage de faisceau (18) diffère de la piste balayée (44) d'une valeur prédéfinie, un signal de réglage de position est généré,
- dans lequel la position du faisceau d'écriture (10) sur le support d'enregistrement (4) est réglée à l'aide du signal de réglage de position, et
- dans lequel l'hologramme est écrit par apport ponctuel d'énergie rayonnante, l'intensité du faisceau d'écriture (10) étant commandée en fonction de la position du faisceau d'écriture (10) sur le support d'enregistrement (4).

2. Procédé selon la revendication 1,
dans lequel le faisceau de balayage est déplacé dans un rapport de déplacement prédéfini au faisceau d'écriture.

3. Procédé selon la revendication 1 ou 2,
dans lequel le faisceau de balayage est focalisé en une taille, qui correspond au maximum à la dimension des pistes du masque de guidage de faisceau.

4. Procédé selon l'une quelconque des revendications 1 à 3,
dans lequel les pistes du masque de guidage de faisceau présentent une réflectivité différente, latéralement à côté des pistes, de la surface environnante et dans lequel le faisceau réfléchi par la surface du masque de guidage de faisceau est détecté, le signal de réglage de position étant dérivé de la distribution d'intensité du faisceau réfléchi.

5. Procédé selon l'une quelconque des revendications 1 à 3,
dans lequel les pistes du masque de guidage de faisceau présentent une propriété de transmission différente, latéralement à côté des pistes, de la surface environnante et dans lequel le faisceau transmis par le masque de guidage de faisceau est détecté, le signal de réglage de position étant dérivé de la distribution d'intensité du faisceau transmis.

6. Procédé selon l'une quelconque des revendications 1 à 3, dans lequel les pistes du masque de guidage de faisceau présentent une structure superficielle et dans lequel le faisceau réfléchi par la surface du masque de guidage de faisceau est détecté, le signal de réglage de position étant dérivé de la distribution d'intensité du faisceau réfléchi.

7. Procédé selon l'une quelconque des revendications 1 à 6, dans lequel le faisceau de balayage présente trois faisceaux partiels s'étendant l'un à côté de l'autre et dans lequel le signal de réglage de position est dérivé, en plus du faisceau central, des intensités de deux faisceaux marginaux.

8. Procédé selon l'une quelconque des revendications 1 à 7, dans lequel un signal de direction est généré au cours du balayage du faisceau de balayage le long de la piste du masque de guidage de faisceau.

9. Procédé selon la revendication 8,
dans lequel deux structures périodiques décalées respectivement d'une phase prédéfinie, de préférence de 90°, se présentent avec différentes propriétés optiques le long des pistes et dans lequel un signal de direction est dérivé des fractions de signal générées par les structures périodiques dans le faisceau détecté.

10. Procédé selon l'une quelconque des revendications 1 à 9,
dans lequel il est prévu un marquage sur au moins une des extrémités de chaque piste, à partir duquel marquage est dérivé un signal de départ ou un signal d'arrêt.

11. Procédé selon la revendication 10,
dans lequel le marquage contient une information d'adresse.

12. Procédé selon la revendication 11,
dans lequel la position de la piste au sein de la pluralité de pistes est dérivée de l'information d'adresse.

13. Procédé selon l'une quelconque des revendications 10 à 12, dans lequel les pistes présentent une suite périodique de sections ayant différentes propriétés optiques, dont il est dérivé un signal de déclenchement pour commander l'intensité du faisceau d'écriture.

14. Procédé selon la revendication 13,
dans lequel un signal de déclenchement périodique, à l'aide duquel l'intensité du faisceau d'écriture est commandée dans le temps, est généré au cours du balayage le long d'une des pistes en partant du signal de départ.

15. Procédé selon la revendication 14,
dans lequel le signal de déclenchement est associé à un signal de commande d'intensité, à l'aide duquel est commandé l'ordre de grandeur de l'intensité du faisceau d'écriture.

16. Procédé selon la revendication 15,
dans lequel le signal de commande d'intensité est dérivé de l'intensité du faisceau de balayage.

17. Procédé selon la revendication 16,
dans lequel le signal de commande d'intensité est enregistré extérieurement dans un support d'enregistrement et la valeur d'intensité correspondante est déterminée à l'aide de la position de la piste et du moment pendant le balayage de la piste.

18. Procédé selon l'une quelconque des revendications 1 à 17,
dans lequel la distance entre un premier objectif pour focaliser le faisceau d'écriture et le support d'enregistrement est ajustée pour une écriture à diverses profondeurs dans le support d'enregistrement.

19. Dispositif lithographique pour produire des hologrammes numériques dans un support d'enregistrement (4), en particulier pour réaliser un procédé selon l'une quelconque des revendications 1 à 15, comprenant :
- une source lumineuse (8) pour générer un faisceau d'écriture (10),
- des moyens d'entraînement (12,14) pour le déplacement bidimensionnel du faisceau d'écriture (10) par rapport au support d'enregistrement (4) et
- un premier objectif (16) pour focaliser le rayon d'écriture (10) sur le support d'enregistrement (4) à inscrire,
- un masque de guidage de faisceau bidimensionnel (18),
- des moyens (20) pour générer un faisceau dé balayage (22),
- dans lequel les moyens d'entraînement (12,14) sont dimensionnés pour déplacer le faisceau de balayage (22) par rapport à la surface du masque de guidage de faisceau (18) et le déplacement du faisceau de balayage (22, 22') est couplé au déplacement du faisceau d'écriture (10),
- un détecteur (30', 30") pour recevoir le faisceau de balayage qui varie en intensité en raison du masque de guidage de faisceau (18), et
- des moyens (36) pour générer un signal de réglage de position,
**caractérisé en ce que**
- il est prévu un second objectif (24) pour focaliser le faisceau de balayage (22, 22') sur le masque de guidage de faisceau (18),
- **en ce que** le masque de guidage de faisceau (18) présente une pluralité de pistes (44) et les moyens d'entraînement pour le déplacement bidimensionnel du faisceau de balayage (22) sont dimensionnés le long d'une de ces pistes, et **en ce qu'**il est prévu des moyens (32, 34) pour ajuster le faisceau d'écriture (10) et le faisceau de balayage (22).

20. Dispositif lithographique selon la revendication 19, **caractérisé en ce que**
les moyens (36) pour générer le signal de réglage de position sont dimensionnés pour commander l'intensité du faisceau d'écriture (10) avec le masque de guidage de faisceau (18).

21. Dispositif lithographique selon la revendication 19 ou 20, **caractérisé en ce que**
les moyens pour ajuster le faisceau d'écriture (10) et le faisceau de balayage (22) se présentent sous la forme d'un dispositif d'actionnement x/y (32, 34).

22. Dispositif lithographique selon l'une quelconque des revendications 19 à 21, **caractérisé en ce que**
- les moyens d'entraînement (12, 14) se présentent sous la forme d'un dispositif à miroir de balayage x/y pour déplacer le faisceau d'écriture (10) et **en ce que**
- les moyens pour générer le faisceau de balayage (22) présentent des moyens (20) pour désaccoupler une partie du faisceau d'écriture (10) lorsque le faisceau de balayage (22) se trouve dans la trajectoire du faisceau d'écriture (10) derrière les moyens d'entraînement (12, 14).

23. Dispositif lithographique selon l'une quelconque des revendications 19 à 21, **caractérisé en ce que**
- les moyens pour générer le faisceau de balayage (22) présentent
- une seconde source lumineuse (26) pour générer un faisceau de balayage (22) d'une longueur d'onde ou d'une polarisation s'écartant de celle du faisceau d'écriture (10) et
- des moyens d'injection (28) pour injecter le faisceau de balayage (22) dans la trajectoire du faisceau d'écriture (10) devant les moyens d'entraînement (12, 14) et **en ce que**
- les moyens de désaccouplage (20) désaccouplent le faisceau de balayage (22).

24. Dispositif lithographique selon l'une quelconque des revendications 19 à 23, **caractérisé en ce que**
un rapport de démultiplication linéique entre le déplacement du faisceau de balayage (22) sur le masque de guidage de faisceau (18) et celui du faisceau d'écriture (10) sur le support d'enregistrement (4) est prédéfini.

25. Dispositif lithographique selon la revendication 24, **caractérisé en ce que**
la distance focale du second objectif (24) est plus grande d'un facteur prédéfini que la distance focale du premier objectif (16).

26. Dispositif lithographique selon l'une quelconque des revendications 19 à 25, **caractérisé en ce que**
les pistes (44) sont aménagées en trame, en particulier en trame orthogonale.

27. Dispositif lithographique selon l'une quelconque des revendications 19 à 26, **caractérisé en ce que**
le masque de guidage de faisceau (18) présente une surface avec différentes propriétés de réflexion.

28. Dispositif lithographique selon la revendication 27, **caractérisé en ce que**
le masque de guidage de faisceau (18) se présente sous la forme d'un modulateur de faisceau spatial.

29. Dispositif lithographique selon l'une quelconque des revendications 19 à 26, **caractérisé en ce que**
le masque de guidage de faisceau (18) présente une surface avec une structure superficielle topographique, sur laquelle est réfléchi le faisceau de balayage.

30. Dispositif lithographique selon l'une quelconque des revendications 27 à 29, **caractérisé en ce que**
dans la trajectoire du faisceau de balayage (22), il est prévu, dans la direction du faisceau, devant les moyens (32, 34) pour ajuster les faisceaux (10, 22), un désaccoupleur de faisceau (18) qui achemine le faisceau de balayage réfléchi sur le détecteur (30',30").

31. Dispositif lithographique selon l'une quelconque des revendications 19 à 26, **caractérisé en ce que**
le masque de guidage de faisceau (18) présente une surface avec différentes propriétés de transmission.

32. Dispositif lithographique selon la revendication 31, **caractérisé en ce que**
le masque de guidage de faisceau (18) se présente sous la forme d'un modulateur de faisceau spatial.

33. Dispositif lithographique selon la revendication 31 ou 32, **caractérisé en ce que**
il est prévu une optique focalisatrice (48) pour focaliser le rayonnement transmis sur le détecteur (30', 30").

34. Dispositif lithographique selon l'une quelconque des revendications 19 à 33, **caractérisé en ce que**
les pistes (44) du masque de guidage de faisceau (18) présentent des marquages comme supports d'informations de positions de pistes.

35. Dispositif lithographique selon l'une quelconque des revendications 19 à 34, **caractérisé en ce que**
les pistes (44) du masque de guidage de faisceau (18) présentent des marquages comme supports d'un signal de départ et le cas échéant d'un signal d'arrêt.

36. Dispositif lithographique selon l'une quelconque des revendications 19 à 35, **caractérisé en ce que**
les moyens de réglage (36) pour générer un signal de réglage de position comportent des moyens informatiques et/ou des moyens d'enregistrement, qui sont reliés aux détecteurs (30', 30").

37. Dispositif lithographique selon l'une quelconque des revendications 19 à 36, **caractérisé en ce que**
les moyens de réglage (36) pour générer un signal de commande d'intensité comportent des moyens informatiques et/ou des moyens d'enregistrement qui sont reliés aux détecteurs (30', 30").

38. Dispositif lithographique selon l'une quelconque des revendications 19 à 37, **caractérisé en ce que**
il est prévu des moyens pour ajuster la distance entre le support d'enregistrement (4) et le premier objectif (16).

39. Microscope pour balayer un objet (4), comprenant :
- une source lumineuse (8) pour générer un faisceau d'observation (10),
- des moyens d'entraînement (12, 14) pour le déplacement bidimensionnel du faisceau d'observation (10) par rapport à l'objet (4),
- un premier objectif (16) pour focaliser le faisceau de balayage (10) sur l'objet (4),
- un masque de guidage de faisceau bidimensionnel (18) avec une pluralité de pistes,
- des moyens (20) pour générer un faisceau de balayage (22),
- un second objectif (24) pour focaliser le faisceau de balayage (22, 22') sur le masque de guidage de faisceau (18),
- dans lequel les moyens d'entraînement (12, 14) déplacent le faisceau de balayage (22) dans deux dimensions par rapport à la surface du masque de guidage de faisceau (18) le long d'une des pistes, le déplacement du faisceau de balayage (22, 22') étant couplé au déplacement du faisceau d'observation (10),
- un détecteur (30', 30") pour recevoir le faisceau de balayage qui varie en intensité en raison des propriétés optiques de la piste (44),
- des moyens (32, 34) pour ajuster le faisceau d'observation (10) et le faisceau de balayage (22),
- des moyens (26) pour générer un signal de réglage de position,
- un photodétecteur (52), et
- un plan de déviation (50) agencé dans la trajectoire du faisceau d'observation réfléchi par l'objet, devant ou derrière le premier objectif (16), pour dévier le faisceau d'observation réfléchi par l'objet sur le photodétecteur (52).
